# EUROPEAN PATENT APPLICATION

(11) **EP 3 255 795 A1**
(43) Date of publication of application: **13.12.2017**
(21) Application number: 16174027.9
(22) Date of filing: 10.06.2016
(51) Int. Cl.: H03K 17/689, H03K 17/78, H03K 17/687

(54) **POWER SWITCH**

(71) Applicant: Goodrich Control Systems, Solihull West Midlands B90 4LA (GB)
(72) Inventor: GIETZOLD, Thomas, Stratford upon Avon, CV37 0BQ (GB)
(74) Representative: Hughes, Andrea Michelle

(57) **Abstract**

The disclosure provides a power switch that can be switched by a logic source in an ON or an OFF state. The switch comprises a component (8) to output an optical signal responsive to the control signal and an optical sensitive device (10) to react to the optical signal and self-conducting JFET (11) in cascode configuration with the optical sensitive device.

## Description

### TECHNICAL FIELD

The present disclosure relates to power switches.

### BACKGROUND

Power switches are used in a very wide range of applications where power conversion is required including but, of course, not limited to aircraft technology. Conventionally, in power electronic circuits, fast semiconductor switches are used which can be controlled to change their state between an 'off' state and an 'on' state. Many switch circuits use electric field effect technologies e.g. junction field effect transistors (JFETs), metal oxide field effect transistors (MOSFETs) or insulated gate bipolar transistors (IGBTs). With such switches, the state of the switch can be controlled by a gate voltage and such circuits require relatively simple control circuitry.

Source-switched or so-called 'cascode' circuits are also known in power switches. A cascode usually comprises a normally-off gating device such as a MOSFET and a normally-on high voltage device such as a JFET. Such switches are generally simple and reliable.

A problem with known MOSFET or IGBT switch arrangements described above is that a gate driver is required, which adds complexity, cost and weight to the system and takes up additional space. Furthermore, such circuits, in many cases, need isolation between the high voltage power side and the low voltage control side to deal with level shifting and noise requirements. To deal with this problem, conventional circuits include additional components such as isolating components like optical isolation circuitry and an isolated or floating power supply for each power switch. Again, these components take up space in the switch and add to its weight, cost and complexity.

It is an aim of the present disclosure to provide a simpler power switch having fewer or no external components.

### SUMMARY

The disclosure provides a power switch responsive to a control signal from a logic source to switch between an ON and an OFF state; an optical component arranged to output an optical signal responsive to the control signal; and a driver device responsive to the optical signals to switch between a non-conductive ( OFF ) state and a conductive ( ON )state.

The power device preferably comprises an optical sensitive device and a self-conducting JFET in a cascode configuration.

The power device may comprise a transistor e.g. a JFET or other field effect transistor such as, e.g. those known from conventional cascode switches or e.g. an IGBT responsive to optical or light signals. One possible embodiment combines a Low voltage Darlington isolator and a high voltage JFET.

Preferred embodiments will now be described by way of example only with reference to the drawings.

### BRIEF DESCRIPTON OF THE DRAWINGS

Fig. 1 is a block diagram of an existing power switch using an IGBT.
Fig. 2 is a block diagram showing a conventional IGBT integrated power module.
Fig. 3 is a block diagram of an optical power switch according to the disclosure.
Fig. 4 is a block diagram of an alternative implementation of an optical power switch according to the disclosure.

### DETAILED DESCRIPTION

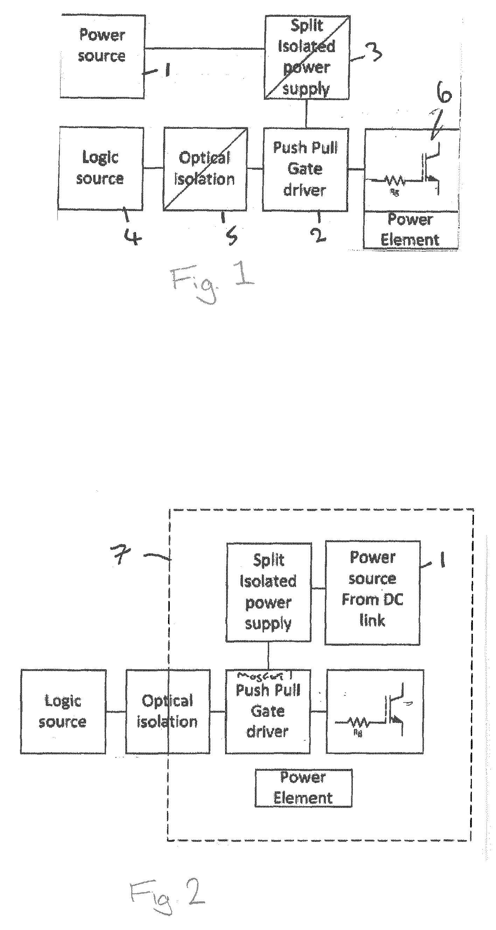

Referring first to figs. 1 and 2, a conventional power switch is described briefly. Such switches are in widespread use and would be readily known to a person skilled in the art. Only a very brief overview will, therefore, be given.

In a conventional power switch such as that shown in Figs. 1 and 2, power from a power source 1 is to be converted to a drive power for a load by the switch. The power source supplies a power signal to a gate driver 2 such as a push-pull gate driver via a split isolated power supply 3. The gate driver is switched between an on and an off state in response to control signals from a controller such as a logic source 4. An optical isolation component 5 is provided between the logic source and the gate driver. A switch element such as a JFET or an IGBT 6 is either conductive or non-conductive in response to the on and off states of the gate driver 2. Depending on the environment in which the switch is used, the optical isolator component could be omitted but the other components will still be needed.

Fig. 2 shows how the above-described components might be incorporated in a package for an integrated power module (IPM). There are limitations to the size of the electronic chip 7 on which the components can be mounted. As can be seen, whilst it is possible to mount many of the elements on the chip, this is difficult and not all components can be accommodated on a single chip.

The present disclosure uses a high speed, high power optical device such as an LED 8 and a light sensitive switch element such as a light sensitive IGBT 9. This then removes the need for the other common circuit elements required by the conventional gate driver arrangement such as the isolating components, drive circuits and floating/split power supplies. The resulting fewer components mean that the entire switch can be easily mounted on a small chip surface.

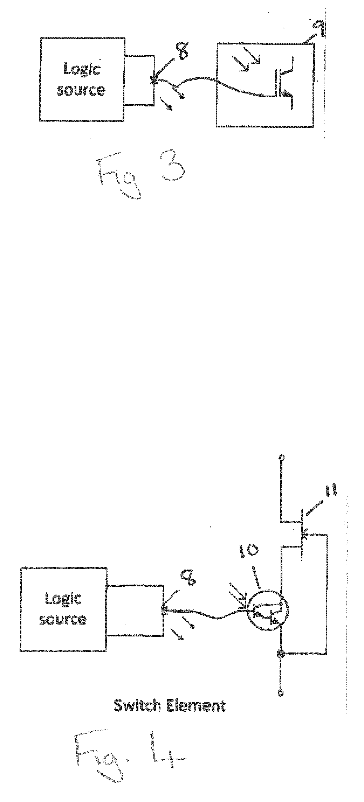

Fig. 4 shows an implementation of the optical power switch of the disclosure where the switch element combines a high current low voltage optical switch element (e.g. Darlington or optical MOSFET) 10 and a high voltage JFET 11.

The optical switch element and the JFET will have to be sized to meet the desired rating of the device in terms of current and voltage rating. Both light sensitive switch element and JFET need to be rated for the current capability of the device. In addition the JFET needs to be able to handle the device's voltage rating. Whereas the voltage rating of the optical device is determined by the voltage the JFET needs, to be blocked, which will be in the range of a 20V.

The optical device or LED 8 can be located close to the light sensitive switch element or remote from the light sensitive device connected by a optical fiber or similar light carrying device.

The switch of the present disclosure combining known technologies such as SiC JFET high power optical devices in a cascode configuration enables the manufacture of simple power stages in drive systems and power supplies without the need for optical isolation, gate drives and floating/split power supplies, thus providing small, reliable, light and inexpensive devices.

## Claims

1. A power switch responsive to a control signal from a logic source to switch between an ON and an OFF state; an optical component (8) arranged to output an optical signal responsive to the control signal; and a driver device (10, 11) responsive to the optical signals to switch between a non-conductive state and a conductive state.

2. The power switch of claim 1, wherein the driver device comprises an optical sensitive device (10) and a self-conducting JFET (11) in a cascode configuration.

3. The power switch of claim 1 or 2, wherein the optical component comprises a light-emitting diode LED.

4. The power switch of claim 2 or 3 when dependent on claim 2 wherein the optical sensitive device comprises a Darlington isolator or other light sensitive high current low voltage device.
